**Europäisches Patentamt**

(19) **European Patent Office**

**Office européen des brevets**

(11) Publication number : **0 412 475 B1**

# (12) EUROPEAN PATENT SPECIFICATION

(45) Date of publication of patent specification :
**10.11.93 Bulletin 93/45**

(51) Int. Cl.⁵: **C23G 5/032,** C23G 5/024, C11D 7/50

(21) Application number : **90115043.3**

(22) Date of filing : **04.08.90**

(54) **Cleaning composition of dibasic ester and hydrocarbon solvent, and cleaning process.**

(30) Priority : **07.08.89 US 392996**
**07.08.89 US 392997**
**07.08.89 US 392998**

(43) Date of publication of application :
**13.02.91 Bulletin 91/07**

(45) Publication of the grant of the patent :
**10.11.93 Bulletin 93/45**

(84) Designated Contracting States :
**AT BE CH DE ES FR GB GR IT LI LU NL SE**

(56) References cited :
**EP-A- 0 164 467**
**EP-A- 0 287 705**
**EP-A- 0 351 810**
**RESEARCH DISCLOSURE, no. 299, March 1989, abstract no. 29927; "Gasoline engine fuel system cleaner"**
**IDEM**

(73) Proprietor : **E.I. DU PONT DE NEMOURS AND COMPANY**
**1007 Market Street**
**Wilmington Delaware 19898 (US)**

(72) Inventor : **Dishart, Kenneth Thomas**
**319 Walden Road**
**Wilmington, Delaware 19803 (US)**
Inventor : **Wolff, Mark Cutler**
**10988 Appaloosa Drive**
**Richwood, Kentucky 41094 (US)**
Inventor : **Jackson, Harold Leonard**
**102 Stratton Drive**
**Hockesson, Delaware 19707 (US)**

(74) Representative : **von Kreisler, Alek, Dipl.-Chem. et al**
**Patentanwälte Von Kreisler-Selting-Werner, Postfach 10 22 41, Bahnhofsvorplatz 1**
**D-50462 Köln (DE)**

## Description

The present invention relates to a method for cleaning a printed circuit board or for removal of solder flux from a surface of a printed circuit board.

Prior to a soldering operation for attachment of components to printed circuit boards it is conventional and essential to apply a soldering flux to insure an adherent bond of solder. The printed circuit board may be protected with a solder mask which covers all areas of the substrate except where solder is to contact and adhere to a conductive surface portion. Application of flux and solder can be done by hand, wave or reflow methods. In wave soldering the substrate is mechanically conveyed over and contacted with the flux and then with a molten solder wave. The solder adheres to all conductive surfaces on the substrate except where solder mask is present. In reflow soldering a solder paste, containing both flux and solder metal in powder form, is applied only to the points where solder bonds are to be made. Components are set in place and the entire printed circuit board assembly is heated to melt the solder. Flux which remains on the assembly after soldering can cause premature failure of the electrical circuitry through corrosion, absorption of water and other effects and must be removed.

In Hayes et al. U.S. Patent 4,640,719 use of terpene compounds is disclosed in cleaning printed wiring boards. This patent discloses cleaning of residual flux and particularly rosin solder flux and adhesive tape residues employing terpene compounds such as pinene including its alpha and beta isomer, gamma terpinene, delta-3-carene, limonene and dipentene with limonene and dipentene preferred. Dipentene is the racemic mixture of the limonene optically active isomers. This patent further discloses that these terpene compounds are almost completely insoluble in water and cannot be directly flushed away by water. Therefore in a preferred embodiment terpene compounds are combined with one or more emulsifying surfactants capable of emulsifying terpenes with water to facilitate their removal.

Research Disclosure No. 299, March 1989, abstract No. 29927 discloses a gasoline engine fuel cleaner containing an alkyl diester, a gasoline detergent, a rust inhibitor and one or more non-halogen containing organic solvents for cleaning clogged fuel injectors.

EP-A- 0 287 705 discloses compositions containing dibasic esters and hydrocarbon solvents for cleaning processing plants.

EP-A-0 164 467 discloses compositions containing alkylaromatic hydrocarbons and olefins having a boiling point of at least 100°C and a co-slovent which may be a diester for the removal of spots and stains from fabrics.

The present invention is directed to a process for cleaning a printed circuit board or for removal of solder flux from a surface of a printed circuit board with a cleaning composition which consits essentially of (a) a dibasic ester solvent and (b) a hydrocarbon solvent wherein the definition of hydrocarbon solvent excludes a terpene.

In a further embodiment of the invention the cleaning composition contains a compatibilizing component such as a surfactant. In a yet further embodiment of the invention the cleaning composition contains a compatibilizing surfactant with water.

The cleaning composition used according to the present invention is employed on printed circuit board surfaces particularly one to which residual excess flux is present such as after a solder operation. A preferred substrate surface is a printed circuit board surface which may or may not be protected by a solder mask permanent coating in areas where solder is not to adhere. In the present disclosure printed circuit board is employed in a generic sense and is inclusive of printed wiring boards.

In the present invention a combination of a dibasic ester solvent is employed with a hydrocarbon solvent and this combination is considered to be a replacement over the use of chlorofluorocarbon (CFC) solvents which are presently employed as cleaning agents with particular suitability in cleaning printed circuit boards. Optionally the cleaning composition additional contains a compatibilizing component as a surfactant. Further optionally and most preferred method is present in conjunction with an added compatibilizing surfactant. An azeotrope of trichlorotrifluoroethane and methanol such as sold under the trademark Freon TMS® by E. I. du Pont de Nemours and Company is superior to known methods of cleaning solder flux from a surface of a printed wiring board. However the use of fully halogenated chlorofluorocarbon materials are considered to present a threat to the environment because of their involvement in stratospheric ozone depletion. Therefore any improvement in alternative cleaning compositions which do not contain a fully halogenated CFC is considered significant. In accordance with the present invention residual ionic contaminants are reduced to low levels (even though such levels may be somewhat higher than cleaning with a fully halogenated CFC methanol azeotrope). However the results herein are considered to be a significant improvement compared to use of other cleaning agents including use of a terpene compound in combination with an emulsifying agent.

In accordance with the present invention a dibasic ester or combination of dibasic ester solvents is employed. Dibasic ester is employed in its normal definition and include typical dialkyl esters of dicarboxylic acids (dibasic acids) capable of undergoing reactions of the ester group, such as hydrolysis and saponification. Conventionally at low and high pH they can be hydrolyzed to their corresponding alcohols and dibasic acids or acid salts. Preferred dibasic ester solvents are: dimethyl adipate, dimethyl gluterate and dimethyl succinate and mixtures thereof. Other esters with longer chain alkyl groups derived from alcohols, such as ethyl, propyl, isopropyl, butyl and amyl and mixtures thereof including methyl can be employed. Also the acid portion of these esters can be derived from other lower and higher molecular weight dibasic acids, such as oxalic, malonic, pimelic, suberic, and azelaic acids and mixtures thereof including the preferred dibasic acids. These and other esters can be employed provided they are at least partially soluble with the hydrocarbon solvent and are not classified as flammable liquids (Flash Point at or above 37.8°C (100°F) by Tag Closed Cup method) and have at least 2.0 wt% solubility in water at 25°C. Additionally a compatibilizing component may be added to improve the mutual solubility of the dibasic ester and hydrocarbon solvent.

In the present invention one or more hydrocarbon components are used in combination with the dibasic ester solvent. The type of hydrocarbon component useful in the invention is not critical for the cleaning effectiveness and may be selected from the broad class of aliphatic and aromatic solvents. Preferred hydrocarbon compounds or blends thereof would not be classified as flammable liquids (Flash Point at or above 37.8°C (100°F) by Tag Closed Cup method) and would have solubility parameter ranges for, nonpolar of 6.5 to 10.5, for polar of 0 to 2.5 and hydrogen bonding of 0 to 2.5 based on the three dimensional Hansen Solubility Parameter System with units of the square root of calories per cubic centimeter. More preferred are the above hydrocarbon compounds or blends thereof with Flash Points of 60°C (140°F) or higher. Examples of such hydrocarbon components are the high flash point petroleum derived solvents, such as mineral spirts, naphthas, and aromatics readily available from a variety of suppliers. Specific examples are Exxon "Isopar®," Shell "Soltrol®" and Ashland "Hi-Sol®" solvents. In the present disclosure the use of the term "hydrocarbon solvent" expressly excludes a terpene hydrocarbon.

In addition to the dibasic ester and the hydrocarbon solvent at least one compatibilizing component may be employed to improve the overall mutual compatibility of the blend, i.e., the mutual solubility of the dibasic ester and hydrocarbon solvent. A preferred compatibilizing component is a nonionic surface active agent (surfactant) which not only serves to improve the mutual miscibility of the dibasic ester and hydrocarbon components but also functions to facilitate the emulsification of the hydrocarbon component in the later water rinsing step. Examples of such compatibilizing surfactants are nonionic alcohol ethoxylates, where the alcohol is primary or secondary and has from 10 to 20 carbon units in the chain which can be linear or branched, and where the average number of ethoxylate groups is from 2 to 7.

Instead of the compatibilizing surfactant a compatibilizing solvent may also be used alone or in conjunction with the surfactant to further improve the mutual solubility of the cleaning agent blend particularly where storage and handling at low temperatures is desirable. Examples of such compatibilizing solvents are long chain aliphatic alcohols and esters, glycols, glycol ethers and glycol esters. Examples are 2-ethylhexanol, dipropylene glycol monomethyl ether and dipropylene glycol monomethyl ether acetate. The compatibilizing components must be selected as to not result in a low flash point of the final cleaning agent blend. A combination of compatibilizing surfactant and compatibilizing solvent can be employed.

In the present invention it has been discovered that water in the cleaning composition serves to increase cleaning effectiveness, i.e., measured by a reduction of ionic contamination. The concentration of water is not critical but generally will be in an amount not greater than 2% by weight of the composition. An example of a concentration of water is in a range from 0.1 to 0.5% by weight.

The concentration or ratio of dibasic ester to hydrocarbon solvent is not considered critical and the percentage of these two components can vary with wide ranges such as 5 to 25% dibasic ester and conventionally from 75 to 95% hydrocarbon on the basis of the weight percent of these two components only. Additionally if a combination of esters is employed the respective amounts are not considered critical and commercially available mixtures may be directly utilized.

The amount of compatibilizing component is not critical provided it functions to increase the solubility of the dibasic ester-hydrocarbon solvent combination. Generally the compatibilizing surfactant will not be employed in an amount greater than 15% by weight of the dibasic ester and hydrocarbon solvent combination. Generally the compatibilizing solvent, if needed, can be used for example up to 10% by weight of the total blend.

Additionally if a combination of esters is employed the respective amounts are not considered critical and commercially available mixtures may be directly utilized.

An important criteria in the present invention is a reduction of ionic contamination due to cleaning with a combination of a dibasic ester and hydrocarbon solvent. A preferred substrate for cleaning is a printed circuit board and more particularly a printed circuit board contaminated with rosin flux after a soldering operation. A need for cleanliness on surfaces of the board becomes essential due to defects which can result either at the time of manufacture or subsequently in use of such printed circuit boards. For example corrosion of the circuit board can occur due to contamination from an activated rosin flux.

In the cleaning operation the method of contact of the dibasic ester and hydrocarbon solvent combination is not critical. A preferred method of application of the cleaning composition is by spraying but other conventional contact operations can be employed including a dipping process. Elevated temperature of the cleaning composition is feasible such as a temperature up to 90°C but room temperature material may be directly applied.

After application of the liquid preferably the substrate is rinsed with water such as deionized water. The rinse water may be heated to facilitate the rinsing efficiency.

To illustrate the present invention the following examples are provided.

Example 1

Three hydrocarbon solvent compositions were compared for cleaning efficiency in removal of ionic contamination residues from printed wiring boards (PWBs) using a two-step cleaning process of solvent contact followed by water rinsing.

Solvent 1 was a composition containing terpene hydrocarbons, principally dipentene, with an emulsifying surfactant and was the product tradenamed "Bioact®" EC-7 sold by the Petroferm Company. Such composition contains a small amount of water, i.e., less than 1% by weight.

Solvent 2 and Solvent 3 had compositions in accordance with the teachings of the present invention differing only in the hydrocarbon component and which contained:

| Component | Approximate Wt. % |
|---|---|
| High Flash Hydrocarbon Solvent | 75 |
| Dibasic Esters | 15 |
| Du Pont Merpol SE Surfactant | 10 |

(Merpol®) SE surfactant contained about 4% by weight water)

The hydrocarbon portion of Solvent 2 was a petroleum distillate with a boiling range of 176.7°C (350°F) to 192.8°C (379°F) and was a mixture of 85% cycloparaffins, 14% isoparaffins and 1% n-paraffins by weight with aromatic hydrocarbon content less than 0.05 wt%. Its flash point was 52.8°C (127°F) and it has a low, non-objectionable odor and low toxicity.

The hydrocarbon portion of Solvent 3 was also a petroleum distillate product but with a boiling point range of 204.2°C (400°F) to 227.2°C (441°F) and flash point of 70.5°C (159°F). It was a mixture of 69% cycloparaffins, 29% isoparaffins and 2% n-paraffins by weight with aromatic content less than 0.01 wt%. It also had a low nonobjectionable odor and low toxicity.

The dibasic esters were a mixed dimethyl esters of adipic, glutaric and succinic acids with limited solubility of less than 10% by weight in the hydrocarbon but the surfactant component in the formulation enhances the miscibility. The dibasic ester and surfactant components had flash points of 100°C (212°F) and 92.8°C (199°F), respectively.

PWBs employed in this example were single-sided patterns with 704 holes. Each PWB measured approximately 180.6cm² (28.0 square inches). Circuit patterns were constructed of copper covered with fused tin/lead alloy.

All PWBs were soldered on an Electrovert Econopak II wave soldering machine with a 1.82m (6 feet) per minute belt speed and a 500°C preheater setting to give an approximate 85°C PWB top temperature prior to soldering with a 63/37 by weight eutectic tin/lead solder wave maintained at 250°C. The solder flux applied with a brush prior to the preheat and soldering operation was a commonly used rosin, mildly activated flux (Alpha 611F).

Sets of five printed wiring boards, soldered as described above, were cleaned with each solvent. The boards were individually with the solvent for 4 minutes using 344.7KPa (50 psi). Excess liquid solvent was removed by blowing with compressed air and then the boards were rinsed with water in a 4 stage commercial water cleaner. Rinse time totaled 5 minutes with water temperature maintained at 55°C.

Residual ionic contamination was measured according to military specification method MIL-P-28809 in an "Omega Meter" 600. 2500 ml of 75 weight % isopropyl alcohol and 25 weight % water was used in a 15 minute test. Individual readings were made for each cleaned PWB. The average result for each solvent and the computed standard deviations and variance are shown below.

| | | Average Residual Ionic Contamination, Micrograms NaCl Equivalents 6.45cm² (Sq. Inch) | Standard Deviation | Variance |
|---|---|---|---|---|
| 1. | Solvent 1 | 13.6 | 0.63 | 0.40 |
| 2. | Solvent 2 | 5.4 | 0.43 | 0.19 |
| 3. | Solvent 3 | 7.6 | 1.20 | 1.40 |

These results demonstrate significantly improved cleaning efficiency due to lower ionic residue remaining on the substrate cleaned in Solvents 2 and 3 in comparison with solvent 1 which contained terpene hydrocarbons (and an emulsifying surfactant).

Example 2

Another composition was prepared for comparison with the compositions described in Example 1. Solvent 4 was a composition in accordance with the teachings of the present invention and it contained:

| Component | Approximate Wt% |
|---|---|
| High Flash Hydrocarbon Solvent | 92.5 |
| Dibasic Esters | 7.5 |

The hydrocarbon component was the petroleum distillate product used in the solvent 2 composition of Example 1 with the distillation range of 176.65°C (350°F) to 192.8°C (379°F) and Flash Point of 52.8°C (127°F.)

All PWBs were soldered, cleaned and tested for ionic contamination in accordance with the procedures described in Example 1. The results of the ionic contamination tests are shown below.

| | | Average Residual Ionic Contamination, Micrograms NaCl Equivalents 6.45cm² (Sq. Inch) | Standard Deviation | Variance |
|---|---|---|---|---|
| 4. | Solvent 4 | 6.3 | 1.3 | 1.8 |

These results demonstrate that high cleaning efficiency can be achieved when using no emulsifying surfactant.

Example 3

Other compositions were prepared and tested to determine the influence the amount of water in the composition has on the cleaning performance.

Solvent 4 had composition in accordance within the teachings of the present invention differing only in the surfactant component and which contained:

| Component | Approximate Wt% |
|---|---|
| High Flash Hydrocarbon Solvent | 75 |
| Dibasic Esters | 15 |
| Anhydrous Surfactant | 10 |

The surfactant portion in Solvent 4 was similar to the Du Pont Merpol SE surfactant used in Solvent 2 and Solvent 3 except that it introduced no water to the composition.

Additional compositions similar in components and proportions to Solvent 4 were prepared except water was added.

| Preparation | Approximate Wt% Water |
|---|---|
| Solvent 5 | 0.1 |
| Solvent 6 | 0.5 |
| Solvent 7 | 1.0 |

The hydrocarbon portion of Solvents 4, 5, 6, and 7 was a petroleum distillate product with a boiling point range of 204.5°C (400°F) to 227.2°C (441°F) and flash point of 70.5°C (159°F). It was a mixture of 69% cycloparaffins, 29% isoparaffins and 2% n-paraffins by weight with aromatic content less than 0.01%. It also had a low non-objectionable odor and low toxicity.

The dibasic esters were a mixed dimethyl esters of adipic, glutaric, and succinic acid with limited solubility of less than 10% by weight in the hydrocarbon but the surfactant component in the formulation enhances the miscibility. The dibasic ester and surfactant components has a flash point of 100°C (212°F).

The surfactant portion was an alcohol ethoxylated with an average of 5 moles of ethylene oxide. The alcohol was a secondary alcohol with 12 carbon units in a branched chain. Added water to Solvents 5, 6 and 7 was deionized to 18 megohm-cm resistance.

PWBs employed in this example were double-sided patterns with four tooling holes. Each PWB measured approximately 116.13cm² (18 square inches). The substrate was glass-epoxy with copper circuit patterns covered with fused tin-lead alloy.

All PWBs were soldered, cleaned and tested as described in Example 1 except that the flux employed was a commonly used rosin, fully activated flux (Kester 1585-Mil). The results of ionic contamination tests are shown below.

| | | Average Residual Ionic Contamination, Micrograms NaCl Equivalents 6.45cm² (Sq. Inch) | Standard Deviation | Variance |
|---|---|---|---|---|
| 1. | Solvent 4 | 8.0 | 1.51 | 2.29 |
| 2. | Solvent 5 | 4.1 | 0.71 | 0.51 |
| 3. | Solvent 6 | 3.6 | 0.68 | 0.46 |
| 4. | Solvent 7 | 3.6 | 0.33 | 0.11 |

The results demonstrate that improved cleaning efficiency can be achieved when water is added to the cleaning solvent.

## Claims

1. A process for cleaning a printed circuit board or for removal of solder flux from a surface of a printed circuit board with a cleaning composition which consits essentially of (a) a dibasic ester solvent and (b) a hydrocarbon solvent wherein the definition of hydrocarbon solvent excludes a terpene.

2. The process of claim 1 wherein in the cleaning composition the dibasic ester solvent is a dimethyl ester.

3. The process of claim 1 wherein in the cleaning composition the dimethyl ester solvent is dimethyl adipate, dimethyl glutarate, dimethyl succinate or combination thereof.

4. The process of claim 2 wherein in the cleaning composition a combination of dimethyl ester solvents is employed.

5. The process of claim 1 wherein in the cleaning composition the hydrocarbon solvent is a high flash point aliphatic hydrocarbon or blend thereof with a flash point of 37.8°C (100°F) or higher.

6. The process of claim 1 in which the cleaning composition contains (c) a compatibilizing component which increases the solubility of the dibasic ester-hydrocarbon solvent combination.

7. The process of claim 6 wherein in the cleaning composition the compatibilizing component is another solvent.

8. The process of claim 6 wherein in the cleaning composition the compatibilizing component is a surfactant.

9. The process of claim 6 in which the cleaning composition contains (d) water.


## Patentansprüche

1. Verfahren zur Reinigung einer gedruckten Schaltung oder zur Entfernung von Lötflußmittel von einer Oberfläche einer gedruckten Schaltung mit einer Reinigungs-Zusammensetzung, die im wesentlichen aus
   (a) einem zweibasigen Ester-Lösungsmittel und
   (b) einem Kohlenwasserstoff-Lösungsmittel
   besteht, worin die Definition des Kohlenwasserstoff-Lösungsmittels ein Terpen ausschließt.

2. Verfahren nach Anspruch 1, worin in der Reinigungs-Zusammensetzung das zweibasige Ester-Lösungsmittel ein Dimethylester ist.

3. Verfahren nach Anspruch 1, worin in der Reinigungs-Zusammensetzung das Dimethylester-Lösungsmittel Dimethyladipat, Dimethylglutarat, Dimethylsuccinat oder eine Kombination aus diesen ist.

4. Verfahren nach Anspruch 2, worin in der Reinigungs-Zusammensetzung eine Kombination von Dimethylester-Lösungsmitteln eingesetzt wird.

5. Verfahren nach Anspruch 1, worin in der Reinigungs-Zusammensetzung das Kohlenwasserstoff-Lösungsmittel ein aliphatischer Kohlenwasserstoff mit hohem Flammpunkt oder ein Gemisch aus solchen mit einem Flammpunkt von 37,8 °C (100 °F) oder darüber ist.

6. Verfahren nach Anspruch 1, in dem die Reinigungs-Zusammensetzung eine kompatibilisierende Komponente enthält, die die Löslichkeit der Kombination zweibasiger Ester-Kohlenwasserstoff-Lösungsmittel erhöht.

7. Verfahren nach Anspruch 6, worin die Reinigungs-Zusammensetzung ein anderes Lösungsmittel ist.

8. Verfahren nach Anspruch 6, worin die Reinigungs-Zusammensetzung ein Tensid ist.

9. Verfahren nach Anspruch 6, worin die Reinigungs-Zusammensetzung (d) Wasser enthält.


## Revendications

1. Un procédé pour nettoyer une carte à circuit imprimé ou pour éliminer un flux de soudure de la surface d'une carte à circuit imprimé avec une composition de nettoyage qui consiste essentiellement en:
   (a) un solvant d'ester dibasique et
   (b) un solvant hydrocarboné
   dans lequel la définition du solvant hydrocarboné exclu le terpène.

2. Le procédé selon la revendication 1, caractérisé en ce que dans la composition de nettoyage le solvant d'ester dibasique est l'ester diméthylique.

3. Le procédé selon la revendication 1, caractérisé en ce que dans la composition de nettoyage le solvant d'ester diméthylique est: l'adipate de diméthyle, le glutarate de diméthyle, le succinate de diméthyle ou une combinaison de ces composés.

4. Le procédé selon la revendication 2, caractérisé en ce que dans la composition de nettoyage, on utilise une combinaison de solvants d'ester de diméthyle.

5. Le procédé selon la revendication 1, caractérisé en ce que dans la composition de nettoyage, le solvant hydrocarboné est un hydrocarbure aliphatique à point d'éclair élevé ou à mélange de ce composé qui présente un point d'éclair supérieur ou égal à 37,8°C (100°F).

6. Le procédé selon la revendication 1, dans lequel la composition de nettoyage contient:
(c) un composant comptabilisant qui augmente la solubilité de la combinaison solvant hydrocarboné-ester dibasique.

7. Le procédé selon la revendication 6, caractérisé en ce que dans la composition de nettoyage, le composant comptabilisant est un autre solvant.

8. Le procédé selon la revendication 6, caractérisé en ce que dans la composition de nettoyage, le composant comptabilisant est un tensioactif.

9. Le procédé selon la revendication 6, dans lequel la composition de nettoyage contient:
(d) de l'eau.